**Europäisches Patentamt**

**European Patent Office**

**Office européen des brevets**

(11) Veröffentlichungsnummer: **0 216 037**
**A1**

(12) # EUROPÄISCHE PATENTANMELDUNG

(21) Anmeldenummer: **86109164.3**

(22) Anmeldetag: **04.07.86**

(51) Int. Cl.⁴: **G 01 R 15/06**

(30) Priorität: **23.08.85 CH 3649/85**

(43) Veröffentlichungstag der Anmeldung:
**01.04.87 Patentblatt 87/14**

(84) Benannte Vertragsstaaten:
**CH DE FR LI SE**

(71) Anmelder: **BBC Aktiengesellschaft Brown, Boveri & Cie.
Haselstrasse
CH-5401 Baden(CH)**

(72) Erfinder: **Meppelink, Jan, Dr. Dipl.-Ing.
Lindenhof
CH-5430 Wettingen(CH)**

(54) **Vorrichtung zur Messung des transienten Potentials der Kapselung einer metallgekapselten, gasisolierten Hochspannungsanlage.**

(57) Eine Vorrichtung zur Messung des transienten Potentials ($U_H$) der Kapselung (1) einer metallgekapselten, gasisolierten Hochspannungsanlage weist einen das transiente Potential ($U_H$) der Kapselung (2) erfassenden Spannungsteiler auf sowie ein auf Erde (4) befindliches Messgerät (5), auf dessen Eingang der Ausgang des Spannungsteilers wirkt.

Die Messvorrichtung soll mit vergleichsweise einfachen Mitteln eine genaue Messung aller in metallgekapselten, gasisolierten Hochspannungsanlagen auftretenden transienten Kapselungspotentiale ermöglichen.

Dies wird dadurch erreicht, dass auf der Kapselung (1) eine elektrisch isolierte Messelektrode (8) angeordnet ist, welche mit einer das transiente Potential ($U_H$) der Kapselung (1) führenden Gegenelektrode (10) einen Oberspannungskondensator (11) und mit Erde (4) einen Unterspannungskondensator (12) des Spannungsteilers bildet.

EP 0 216 037 A1

85/85

23.8.85

Ka/eh

- 1 -

## Vorrichtung zur Messung des transienten Potentials der Kapselung einer metallgekapselten, gasisolierten Hochspannungsanlage

Bei der Erfindung wird ausgegangen von einer Vorrichtung zur Messung des transienten Potentials gemäss dem Oberbegriff von Patentanspruch 1.

Mit diesem Oberbegriff nimmt die Erfindung auf einen Stand der Technik Bezug, wie er etwa im Aufsatz "A High-Impedance, Nanosecond Rise Time Probe for Measuring High-Voltage Pulses" von G. Newi in IEEE Transactions on Power Apparatus and Systems, Vol. PAS-87, No. 9, September 1968, insbesondere S. 43 und 44, beschrieben ist. Die bekannte Messvorrichtung enthält im wesentlichen einen ohmschen Messwiderstand, welcher zwischen die Kapselung einer metallgekapselten, gasisolierten Hochspannungsanlage und ein Messkabel geschaltet ist, und ein auf Erdpotential befindliches Messgerät, dessen Messeingang mit dem Messkabel verbunden ist. Bei dieser Vorrichtung bildet der Messwiderstand mit der Wellenimpedanz des Messkabels und der Wellenimpedanz, welche

**0216037**

85/85

durch den Aussenleiter des abgeschirmten Messkabels und Erde gegeben ist, einen ohmschen Spannungsteiler, dessen Ausgangssignal gegenüber dem transienten Kapselungspotential entsprechend dem Grössenverhältnis der genannten Widerstände herabgesetzt ist.

Hierbei ist es jedoch erforderlich, dass der Messwiderstand auch bei hohen Frequenzen des transienten Potentials ohmschen Charakter behält. Daher müssen Laufzeiteffekte und parasitäre Kapazitäten vermieden werden. Dies bedingt eine Ausbildung des Messwiderstandes als räumlich kurzen Schichtwiderstand. Ein solcher Widerstand kann beim Auftreten eines transienten Kapselungspotentials mit einer sehr hohen Spannung pro Längeneinheit beaufschlagt werden, so dass sein Widerstandswert spannungsabhängig und das Messverfahren daher ungenau werden kann.

Die Erfindung, wie sie in den Ansprüchen gekennzeichnet ist, löst die Aufgabe, eine Vorrichtung zur Messung transienter Kapselungspotentiale zu schaffen, welche mit vergleichsweise einfachen Mitteln eine genaue Messung aller in metallgekapselten, gasisolierten Hochspannungsanlagen auftretenden transienten Kapselungspotentiale ermöglicht.

Die erfindungsgemässe Vorrichtung zeichnet sich vor allem dadurch aus, dass sie nahezu rückwirkungsfrei auf die Feldkonfiguration der Hochspannungsanlage ist und in einem sehr weiten, zwischen einigen Hz und einigen Hundert MHz liegenden Frequenzbereich des transienten Kapselungspotentials ein konstantes Teilverhältnis aufweist.

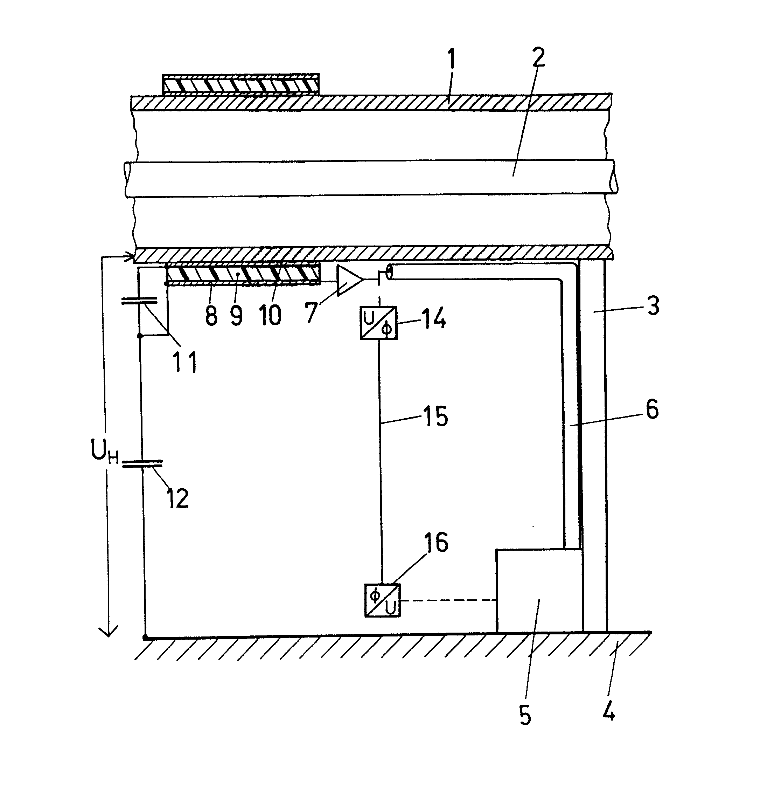

Nachfolgend wird ein Ausführungsbeispiel der erfindungsgemässen Vorrichtung zur Messung des transienten Potentials der Kapselung einer Hochspannungsanlage anhand der Zeichnung näher erläutert.

Hierbei zeigt die einzige Figur eine Ansicht auf einen axial geführten Schnitt durch ein als Rohrleiter ausgeführtes Teil einer Hochspannungsanlage mit einer teilweise schematisch dargestellten erfindungsgemässen Messvorrichtung.

In dieser Figur bezeichnet 1 eine rohrförmig ausgebildete Kapselung aus Metall, wie etwa Aluminium oder Stahl, welche mit einem Isoliergas, wie etwa Schwefelhexafluorid von beispielsweise 4 - 5 bar Druck, gefüllt ist. In der Kapselung 1 ist ein hochspannungsführender Leiter 2 elektrisch isoliert angeordnet. Die Kapselung 1 ist von einer metallenen Traverse 3, welche auf Erde 4 ruht, abgestützt. Auf Erde 4 befindet sich auch ein Messgerät 5, dessen Messeingang mit einem abgeschirmten Messkabel 6 verbunden ist. Das Messkabel 6 ist längs der Traverse 3 und eines Teils der Kapselung 1 an den Ausgang eines vorzugsweise als Operationsverstärker ausgebildeten hochohmigen Impedanzwandlers 7 geführt. Der Eingang des Impedanzwandlers 7 ist mit einer Messelektrode 8 verbunden, welche als metallisierte äussere Fläche einer um die Kapselung 1 gewickelten Folie 9 ausgebildet ist. Die auf der Aussenfläche der Kapselung 1 liegende innere Fläche der Folie 9 ist ebenfalls metallisiert und wirkt als Gegenelektrode 10 eines von der Messelektrode 8 und der metallisierten inneren Fläche gebildeten Oberspannungskondensator 11 (mit einem Kapazitätswert $C_{11}$) eines Spannungsteilers, dessen Unterspannungskondensator 12 (mit einem Kapazitätswert $C_{12}$) von der Messelektrode 8 und Erde 4 gebildet ist.

Die Folie 9 ist im wesentlichen von einem flexiblen dielektrischen Material gebildet, dessen Dielektrizitätskonstante über einen Frequenzbereich von einigen Hz bis zu einigen MHz nahezu unverändert bleibt, und welche darüber hinaus vergleichsweise unempfindlich gegen Tempe-

0216037
85/85

ratureinflüsse ist. Bewährt hat sich eine Folie 9 aus Polyimid mit als Mess 8- und Gegenelektrode 10 wirkenden metallisierten Flächen aus Kupfer. Hierbei kann je nach Anforderungen an die Kapazitätswerte $C_{11}$ und $C_{12}$ von Ober 11- und Unterspannungskondensator 12 die Dicke der Folie 9 einige µm bis zu einigen Hundert µm betragen. Die Dicke der metallisierten Flächen kann entsprechend bemessen sein.

Werden keine allzu grossen Anforderungen an die Messgenauigkeit gestellt, so ist es auch denkbar, die innere Fläche der Folie 9 nicht zu metallisieren und die lediglich aussen metallisierte Folie 9 direkt auf die Kapselung 1 zu wickeln. Die Gegenelektrode 10 wird dann von der Kapselung 1 selbst gebildet. Es ist zweckmässig die Folie 9 mindestens einmal um die Kapselung 1 zu winden, da dann der Oberspannungskondensator 11 im wesentlichen symmetrisch aufgebaut und die Messgenauigkeit besonders gross ist. Falls erforderlich, kann der Kapazitätswert $C_{11}$ des Oberspannungskondensators 11 durch Verwendung einer besonders dünnen Folie 9 in einfacher Weise vergrössert werden.

Die Wirkungsweise der beschriebenen Vorrichtung ist nun wie folgt:
Beim Auftreten transienter Kapselungspotentiale mit Frequenzen von einigen Hz bis zu einigen Hundert MHz und mit Spannungen bis zu einigen Hundert kV, die etwa durch beim Schalten von Trennschaltern entstehende Wanderwellen hervorgerufen werden können, wird das in der Kapselung 1 und der Gegenelektrode 10 geführte, transiente Kapselungspotential $U_H$ entsprechend dem Kapazitätsverhältnis des Ober 11- und des Unterspannungskondensators 12 aufgeteilt und wird an der Messelektrode 8 ein Messignal $U_N$ gebildet, welches die nachfolgend angegebene Grösse

$$U_N = \frac{C_{12}}{C_{11} + C_{12}} \cdot U_H$$

aufweist.

Um zu verhindern, dass der Oberspannungskondensator 11 über den Wellenwiderstand des Messkabels 6 entladen wird, kann das Messignal $U_N$ lediglich über den hochohmigen Impedanzwandler 7 in das Messkabel 6 treten. Da das Messkabel 6 stets an einem Ort geführt ist, an dem die Kapselung 1 mit Erde 4 verbunden ist, etwa der Traverse 3, kann es nahezu ungestört zum geerdeten Messgerät 5 gelangen.

In entsprechender Weise kann das Messignal $U_N$ ebenfalls nahezu ungestört auf das Messgerät 5 wirken, wenn wie in der Figur dargestellt ist, das Messignal $U_N$ in einem auf Kapselungspotential befindlichen und etwa als lichtemittierende Diode ausgebildeten elektro-optischen Wandler 14 in ein Lichtsignal umgewandelt wird, das Lichtsignal etwa über einen Lichtleiter 15 in einen auf Erdpotential befindlichen und etwa als Fotodiode ausgebildeten optoelektrischen Wandler 16 gelangt, dort in ein dem Lichtsignal und damit auch dem Messignal $U_N$ proportionales elektrisches Signal umgewandelt wird, welches sodann zum Messgerät 5 gelangt. Bei einer solchen Signalübertragung können Erdverbindungen, wie die Traverse 3, entfallen und kann zudem keine Verfälschung des Messignals $U_N$ durch Störfelder auftreten.

-6-

(nur für die Prüfungsstelle bestimmt, nicht Teil der Anmeldung)

**0216037**

<u>BEZEICHNUNGSLISTE</u>

85/85

| | |
|---|---|
| 1 | Kapselung |
| 2 | Leiter |
| 3 | Traverse |
| 4 | Erde |
| 5 | Messgerät |
| 6 | Messkabel |
| 7 | Impedanzwandler |
| 8 | Messelektrode |
| 9 | Folie |
| 10 | Gegenelektrode |
| 11 | Oberspannungskondensator |
| 12 | Unterspannungskondensator |
| 14 | elektro-optischer Wandler |
| 15 | Lichtleiter |
| 16 | opto-elektrischer Wandler |

PATENTANSPRÜCHE

1. Vorrichtung zur Messung des transienten Potentials ($U_H$) der Kapselung (1) einer metallgekapselten, gasisolierten Hochspannungsanlage mit einem das transiente Potential ($U_H$) erfassenden Spannungsteiler und mit einem auf Erdpotential befindlichen Messgerät (5), auf dessen Eingang der Ausgang des Spannungsteilers wirkt, dadurch gekennzeichnet, dass auf der Kapselung (1) eine in elektrisch isolierender Weise befestigte und auf das Messgerät (5) wirkende Messelektrode (8) angeordnet ist, welche mit einer das transiente Potential ($U_H$) der Kapselung (1) führenden Gegenelektrode (10) einen Oberspannungskondensator (11) und mit Erde einen Unterspannungskondensator (12) des Spannungsteilers bildet.

2. Vorrichtung nach Anspruch 1, dadurch gekennzeichnet, dass die Gegenelektrode (10) Teil der Kapselung (1) ist.

3. Vorrichtung nach Anspruch 1, dadurch gekennzeichnet, dass die Mess (8)- und die Gegenelektrode (10) von den einander gegenüberliegenden metallischen Flächen einer Folie (9) aus dielektrischem Material gebildet sind.

4. Vorrichtung nach Anspruch 3, dadurch gekennzeichnet, dass die Folie (9) Polyimid enthält.

5. Vorrichtung nach einem der Ansprüche 3 oder 4, dadurch gekennzeichnet, dass die Folie (9) mindestens einmal um die Kapselung (1) gewickelt ist.

6. Vorrichtung nach einem der Ansprüche 1 bis 5, dadurch gekennzeichnet, dass zwischen die Messelektrode (8) und ein abgeschirmtes Messkabel (6) des Messgeräts (5) ein hochohmiger Impedanzwandler (7) geschaltet ist.

7. Vorrichtung nach Anspruch 6, dadurch gekennzeichnet, dass das Messkabel (6) an einer die Kapselung (1) haltenden Traverse (3) an das Messgerät (5) geführt ist.

8. Vorrichtung nach einem der Ansprüche 1 bis 6, dadurch gekennzeichnet, dass an der Kapselung (1) ein der Messelektrode (8) nachgeschalteter elektro-optischer Wandler (13) angebracht ist, dessen Ausgang auf den Eingang eines dem Messgerät (5) vorgeschalteten opto-elektrischen Wandlers (16) wirkt.

Europäisches
Patentamt

EUROPÄISCHER RECHERCHENBERICHT

Nummer der Anmeldung
**0216037**

EP 86 10 9164

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-3 145 255 (BROWN, BOVERI & CIE) * ganzes Dokument * | 1,3,5 | G 01 R 15/06 |
| A | DE-A-2 746 570 (ERO-STARKSTROM KONDENSATOREN) * Anspruch 1, Figur * | 8 | |
| A | DE-B-2 758 800 (SIEMENS AG) * Spalte 1, Zeile 40 - Spalte 2, Zeile 22 * | | |
| D,A | IEEE TRANSACTIONS ON POWER APPARATUS AND SYSTEMS, Band PAS-87, Nr. 9, September 1968, Seiten 1779-1785, US; G. NEWI "A high-impedance, nanosecond rise time probe for measuring high-voltage impulses" * Seiten 1779-1785 * | | RECHERCHIERTE SACHGEBIETE (Int. Cl.4) G 01 R 15/06 |

Der vorliegende Recherchenbericht wurde für alle Patentansprüche erstellt

| Recherchenort | Abschlußdatum der Recherche | Prüfer |
|---|---|---|
| BERLIN | 18-11-1986 | LEMMERICH J |